# EUROPEAN PATENT APPLICATION

(11) **EP 1 672 547 A1**
(43) Date of publication of application: **21.06.2006**
(21) Application number: 04106614.3
(22) Date of filing: 15.12.2004
(51) Int. Cl.: G06F 17/50

(54) **Event-driven model generated from an ordered natural language interface**

(71) Applicant: C.R.F. Società Consortile per Azioni, 10043 Orbassano (Torino) (IT)
(72) Inventor: Carignano, Massimo C.R.F. Società Consortile p. A., 10043 Orbassano (IT); Pacciolla Andrea C.R.F. Società Consortile p. A., 10043 Orbassano (IT); Milizia, Massimo c/o Società Consortile per Azioni, 10043 Orbassano (IT)
(74) Representative: Jorio, Paolo

(57) **Abstract**

A method and system is disclosed for converting statements entered in an ordered natural language into an event-driven model, which may be easily parsed to discover missing or contradictory conditions. A user interface allows a user to enter functional requirements of a design into the system in a well-defined manner. An ordered natural language parser checks each phrase entered by the user for syntax errors and alerts the user of errors or unclear statements. Once any ambiguities are resolved, an engine generates a dynamic event-driven sub model. A parser checks the sub model for logical errors, such as missing or contradictory conditions and alerts the user of the same. A second engine then generates a complete dynamic event-driven model, which can be a combination of several sub models. The complete model can then be simulated and validated.

## Description

The present invention relates generally to event-driven models, and, more particularly, to generating event-driven models based on an ordered natural language interface.

Embedded systems power today's technology products, from simple, everyday consumer electronic devices to complex industrial systems. As hardware and memory become less expensive and more powerful, embedded systems will become even more pervasive. At the same time, the designs will be more complex. To meet this demand, embedded systems engineers must find ways to develop correct, efficient software and hardware at an even faster rate.

Most development processes share a similar workflow, involving four fundamental activities including 1) requirements and specifications, 2) design, 3) implementation and 4) test and verification. With traditional development, the requirements and specifications are document-based, which can be incomplete, ambiguous, and easily misunderstood. The design team who receives these specifications must typically build physical prototypes of the system to validate their designs. The expense and complexity of developing these prototypes often limit the number of iterations designers can perform to refine the design to meet specifications.

Software and hardware implementation is typically done by manually coding in traditional programming and hardware description languages, and by interpreting design specification documents. This manual coding is time-consuming, and can introduce errors in the implementation. Only when the implementation is complete is it possible to test the entire system. However, at this late stage, errors are expensive to fix and can delay or jeopardize the entire project.

Model-Based Design helps engineers and designers overcome the difficulties of traditional development approaches. Comprehensive, system-level mathematical models form the basis of Model-Based Design. Models serve as executable specifications, replacing ambiguous text documents. Models are easy to share with designers, and reduce their need to build physical prototypes.

Instead, designers can simulate and iterate as many times as necessary to refine the model to meet the constraints of the target environment, and to validate the system behavior against the requirements. Once the design is refined and validated, designers can automatically generate code from the model, eliminating the need for hand coding and the errors that manual coding can introduce. Engineers can ensure quality throughout the development process by integrating tests into the models at any stage. This continuous verification and simulation helps identify errors early, when they are easier and less expensive to fix.

One example of a model-based design tool is called MATLAB®, which is a high-level language and development tool that allows quick development and analysis of algorithms and applications.

This tool and other model-based tools generally have language that supports vector and matrix operations that are fundamental to engineering and scientific problems. It enables fast development and execution. With the language of a model-based tool, one can program and develop algorithms faster than with traditional languages because there is no need to perform low-level administrative tasks, such as declaring variables, specifying data types, and allocating memory. At the same time, a model-based tool provides all the features of a traditional programming language, including arithmetic operators, flow control, data structures, data types, object-oriented programming (OOP), and debugging features.

Model-based tools enable designers to apply a Model-Based Design in a graphical, interactive environment, where they can visualize their system models and subsystem designs using intuitive block diagrams. The models are hierarchical and the designer can partition the system into functional units, enabling easy understanding and comprehension of the design and the interaction of subsystems. Each one of these functional units becomes an element of the design that can be reused in subsequent design efforts, even when those projects employ different target hardware.

A model of the embedded system defines all the information needed to implement the software or hardware, including, for example, fixed-point and timing behaviour. Simulation is used to show that the executable specification defined by the model is complete and works correctly with the model of the physical system in which it will reside. Engineers can then automatically generate the code for final system testing, verification, and deployment.

However, there still exists a problem with a model-based design tool. Generally, the person drafting the requirements does not have the technical skill to use the model-based design tool. Thus, many companies still have specialists that must interpret the requirement documents and build the model based on this interpretation. This results in problems of interpretation and also creates problems if the requirements document is incomplete.

Thus, a system is needed to allow a user with limited technical skill to create requirement documents wherein checks are automatically performed to determine if the requirement documents are complete and without contradiction.

The present invention therefore provides a method and system for generating a design through the use of an ordered natural language interface that overcomes the shortcomings of the prior art. The tool iteratively and interactively helps the user to create event-driven models deduced from concepts expressed through an ordered natural language.

According to the invention, a method is disclosed according to claim 1 to convert the ordered natural language to a mathematical model. Furthermore, a system for converting an ordered natural language to a mathematical model is provided according to claims 12 and 18.

For a better understanding of the present invention, a preferred embodiment, which is intended purely by way of example and is not to be construed as limiting, will now be described with reference to the attached drawings, wherein:
Figure 1 shows a flowchart of a method to generate event-driven models from an ordered natural language interface.
Figure 2 shows a detailed flowchart of the method of Figure 1.
Figure 3 is a detailed flowchart showing elements identified for converting from an ordered natural language to a mathematical model.
Figure 4 shows a detailed flowchart of generating a type of event-driven model.
Figure 5 is a system diagram including an ordered natural-language interface.
Figure 6 is a detailed example of a user interface of Figure 5.
Figures 7-12 are examples of finite state machines produced using the present invention.

The following discussion is presented to enable a person skilled in the art to make and use the invention. Various modifications to the embodiments will be readily apparent to those skilled in the art, and the generic principles herein may be applied to other embodiments and applications without departing from the spirit and scope of the present invention. Thus, the present invention is not intended to be limited to the embodiments shown, but is to be accorded the widest scope consistent with the principles and features disclosed herein and defined in the attached claims.

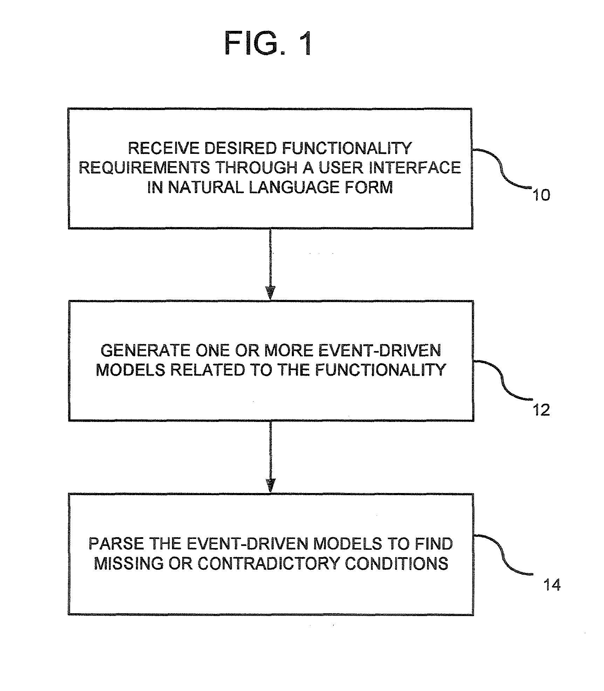

Figure 1 shows a flowchart of a method to generate event-driven models. An event-driven model is a model that reacts to events rather than to time. An example event-driven model is a state machine, which is a model of computation including a set of states, inputs, and transition functions that maps inputs and current states to next states. Computation begins at a start state and changes to new states based on a transition function. There are many variations, such as machines having actions (outputs) associated with transitions (Mealy machine) or states (Moore machine).

In process block 10, functionality requirements are received through a user interface in an ordered natural-language form. As described more fully below, the user interface may include separate fields that require the user to put the natural language in a regimented or ordered form by separately completing the fields. By so doing, the user enters the functionality requirements of the system into the user interface. In process block 12, one or more event-driven models are generated related to the functionality requirements in block 10. The event-driven models are mathematical models of the functionality requirements that make state changes based on events, rather than time. In process block 14, the event-driven models are parsed to find missing or contradictory conditions. Because the functionality requirements are transformed from an ordered natural language to a mathematical model, it is much simpler to perform the parsing. Missing conditions are unidentified conditions that are needed to precisely define the behaviour. Contradictory conditions are those wherein if an event occurs, two different states are identified as the end states. In any event, the errors can be displayed to the user through the user interface so that the user can effectuate changes.

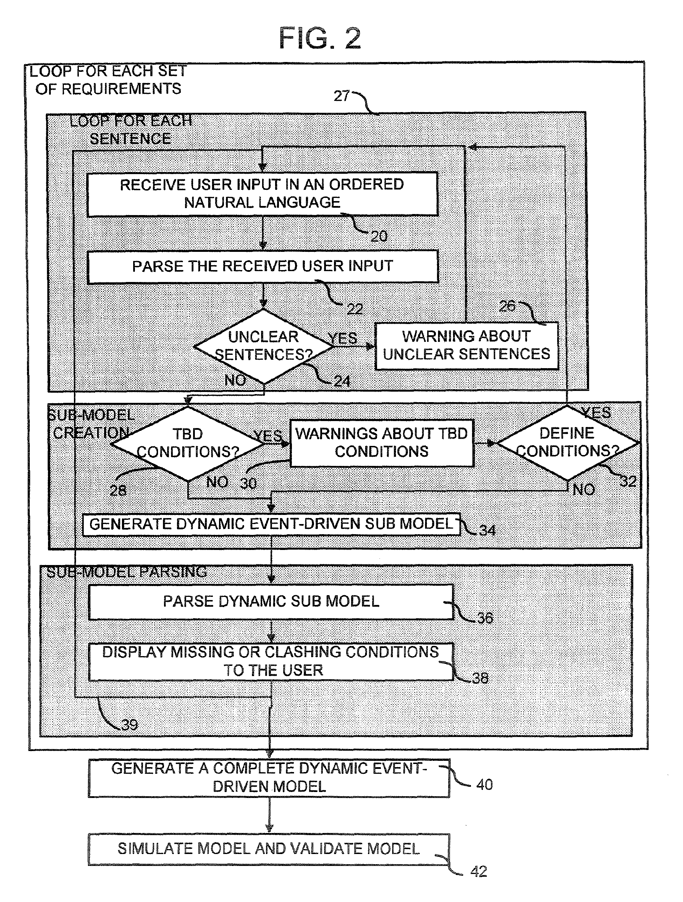

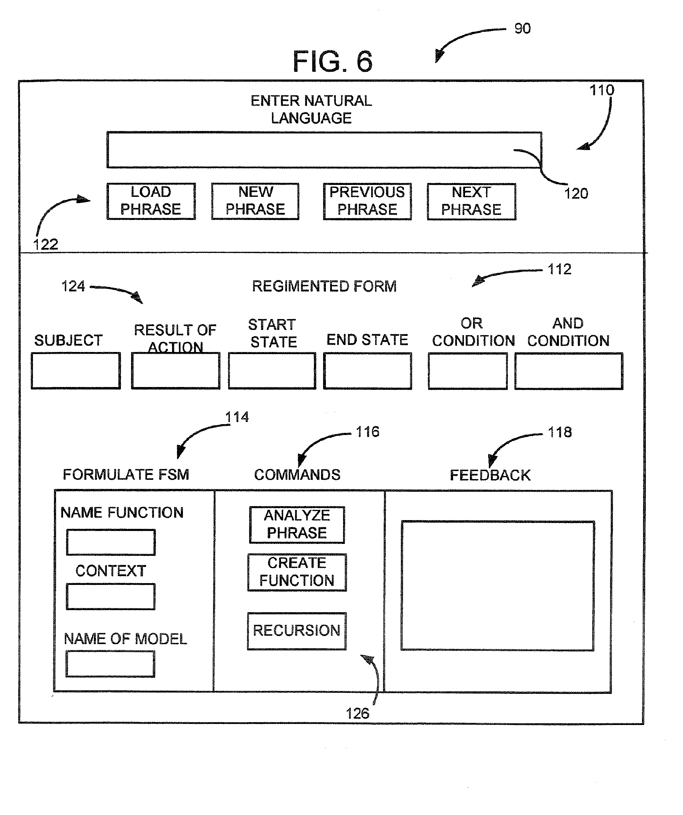

Figure 2 shows a more detailed flowchart of the method. In process block 20, user input is received in an ordered natural language. The input is ordered in that the user enters the functionality requirements in a specified format with precise rules of grammar. One example of such a format is to identify different fields that the user fills with the requested information. Such an ordered format is further illustrated in Figure 6 and is discussed more fully below. Continuing with Figure 2, in process block 22, a parser checks for syntax errors in the ordered natural language that the user entered, such as not following the proper grammar rules of the system. One simplistic example could be if the user enters A===B, the parser would identify that three equal signs in succession are not syntactically correct. In decision block 24, if there are syntactically questionable sentences, warnings are posted to the user interface (process block 26). The user can choose to clarify the sentence or skip the clarification. On the other hand, if all of the sentences are clear and free of syntax problems, the process continues. As indicated at 27 there is a loop of process boxes 20, 22, 24 and 26 whereby the user may enter in any desired number of sentences and for each unclear sentence, warnings will be posted. After all of the sentences related to the functionality requirements are entered, in decision block 28, the system checks if "to be defined" (TBD) conditions were entered by the user. TBD may be entered in the user interface when certain conditions are not yet defined. However, when such TBD conditions still exist, they are detected in decision block 28 and warnings are posted to the user (process block 30). In decision block 32, the user is prompted whether they wish to define the TBD conditions. If yes, the process continues at process block 20 so that the user can enter the conditions into the user interface. If the answer to either decision block 28 or 32 is no, then a dynamic event-driven sub model is generated in process block 34. Thus, the sentences entered into the user interface are converted into an event-driven mathematical model. This allows the ordered natural language entered by the user to be converted into a more formal language that can be checked by existing tools. With all of the sentences now in a mathematical model, a parser can check for missing and/or contradictory conditions. Unlike the parsing of process block 22 where syntax is checked without a logical check, in process block 36, the logic of the mathematical model generated by process block 28 is analyzed. In process block 38, the user is displayed any missing or contradictory conditions. As shown at arrow 39, the user can correct the errors by re-entering sentences in the user interface. If there are no more contradictory or missing conditions, the process continues at process block 40 wherein a complete dynamic event-driven model is generated. Process block 40 may combine several event-driven sub models that were separately processed into a finalized model. In process block 42, the final model can be simulated to test the functionality and validated, such as through using test patterns. If desired, the user may also request that code be generated (not shown).

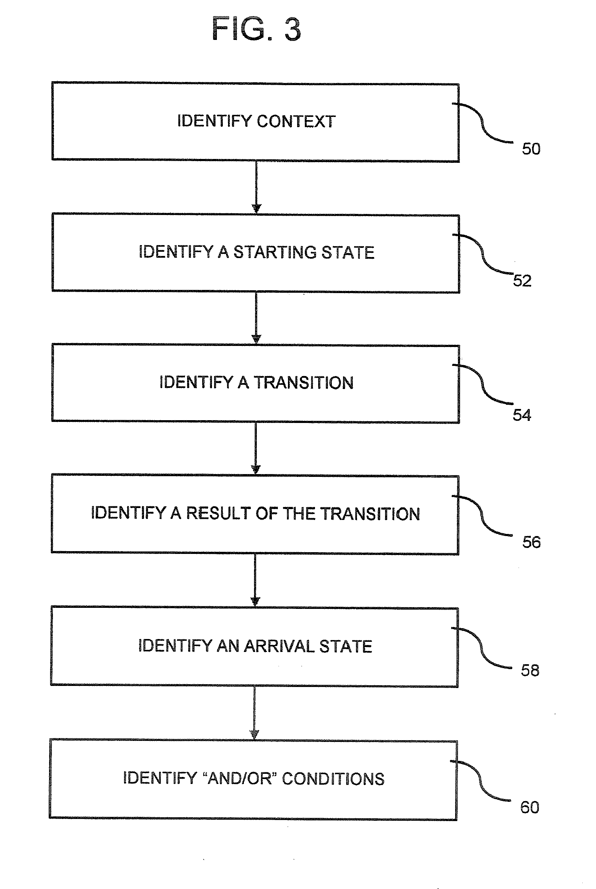

Figure 3 shows a specific case wherein the event-driven model is a state machine. A flowchart of elements are identified through the ordered natural language in order to generate the state machine sub model. In process block 50, a context is identified. The context indicates where the action occurs. In process block 52, a start state is identified. The starting state indicates the initial conditions of operation. In process block 54, a transition is identified. The transition produces the effect of a passage between a starting state and an arrival state. In process block 56, the result of the transition is identified. In process block 58, an arrival state is identified, which is the state arrived at because of the occurrence of a transition. Finally, in process block 60 any "AND/OR" conditions are identified. AND conditions are verified simultaneously whereas OR conditions are verified individually.

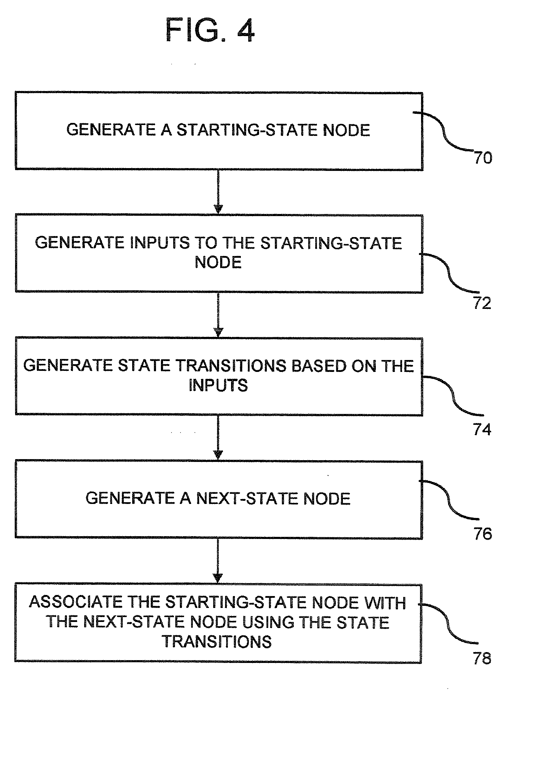

Figure 4 shows a flowchart for a specific example wherein the generated event-driven model is a state machine. To generate a mathematical model, such as a state machine, from an ordered natural language sentence, in process block 70, a starting-state node is generated. The starting state node corresponds to the starting state identified in process block 52 of Figure 3. In process block 72, inputs to the starting state are generated. The inputs carry the data monitored by starting state. In process block 74, state transitions are generated based on the inputs. That is, for every change in state of the inputs, a transition is defined. In process block 76, a next-state node is generated. Finally, in process block 78, an association is made between the starting-state node and the next-state node using the state transitions. Thus, the state machine starts in the start state node and jumps to the next-state node based on the input transitions.

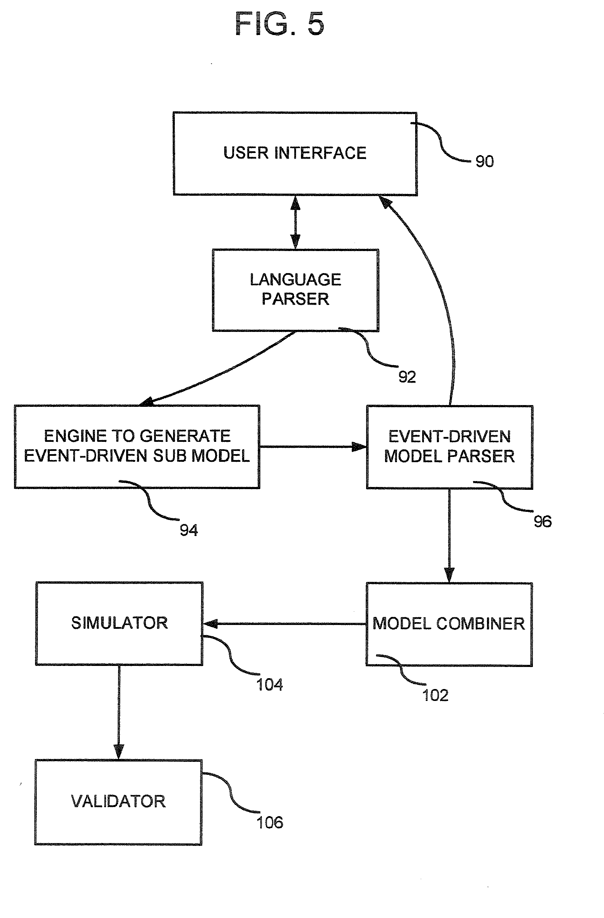

Figure 5 shows a system for carrying out the method of Figure 2. A user interface is shown at 90, an example of which is shown in detail in Figure 6. An ordered natural language parser 92 is coupled to the user interface 90 and analyzes the syntax of the entered functionality requirements. The output of the parser 92 is used to generate warnings on the user interface regarding syntax errors. An engine 94 is used to generate the event-driven sub model. A parser 96 is used to analyze the output of the engine 94 and generate error messages to the user interface for missing or contradictory conditions. A model combiner 102 is used to generate the complete event-driven model by combining together several sub models. The simulator 104 simulates the output of the model combiner and the validator 106 is used to validate the design.

Figure 6 shows an example of the user interface 90. The user interface includes a natural language area 110, a regimented or ordered natural language area 112, an area for identifying context 114, a command area 116, and a feedback area 118. A window 120 displays the functionality requirements from a file (not shown). Buttons shown generally at 122 allow the operator to move through the file of functionality requirements to load a phrase, view a new phrase, view a previous phrase, or view a next phrase. The user then reads the functionality requirements in the window 120 and enters corresponding data in a regimented form in area 112. This area 112 includes six fields shown generally at 124 including a subject, result of action, start state, end state, OR condition, and AND condition. The area 114 contains the information which is extracted or deduced from the ordered natural language statement and which identifies the context of what was described in the ordered natural language. The commands area 116 has buttons shown generally at 126 that allow a phrase to be analyzed, created, or to perform recursive tracing, which enables interaction with the user and re-interpretation of the words or rules that the algorithm has not been able to interpret. The feedback area 118 contains a window for displaying statements that the algorithm has not been able to interpret.

An example of the method is given as follows.

It is desired to create a dynamic model starting from the statement "If V is higher than 18V and the temperature is lower than 10°C, then the de-excited coil passes to the excited state." In this case, the statement does not have the structure of a syntagmatic type, and hence it is desirable to regiment it.

The statement that the user is asked to specify can be the following: "The de-excited coil passes to the excited state if V is higher than 18V and the temperature is lower than 10°C." This sentence is semi-regimented and it is possible to identify various syntagmas and in particular the actions and the conditions of occurrence.
Context=where the action occurs
SN=the coil (name of the elementary automaton).
Action:
Starting state= de-excited
Result of action= passes to the excited state
Arrival state=excited
Conditions of occurrence (AND):
   Condition 1= V is higher than 18V
      AND
   Condition 2= the temperature is lower than 10°C.

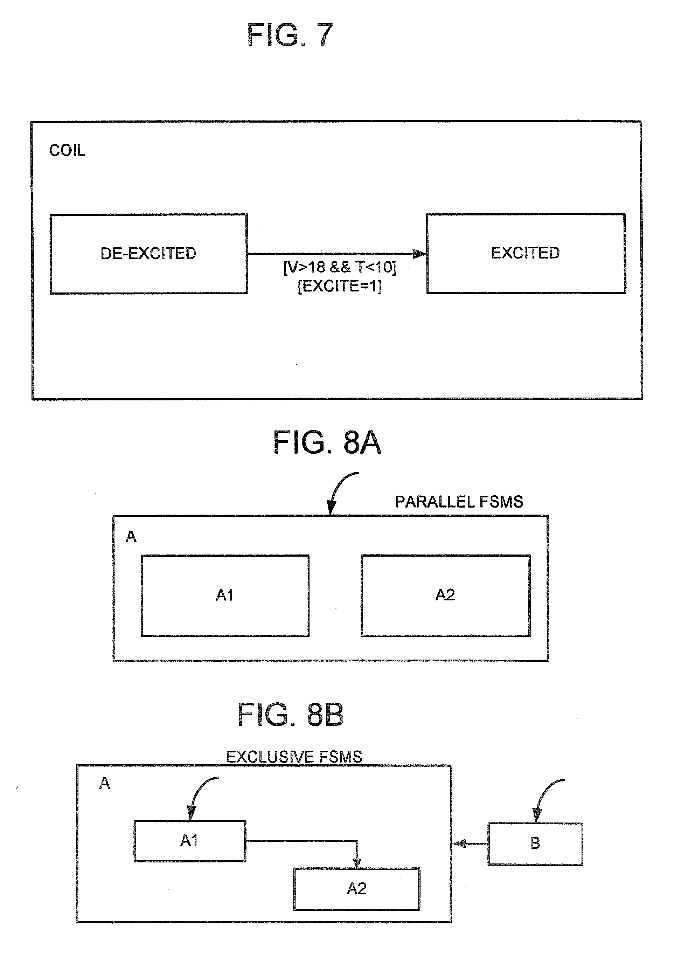

With this type of structure, it is possible to identify the nominal syntagma (i.e., the subject of the sentence), which is the coil. From the analysis of the verbal syntagma, it can be seen that the result of the action is "passes to the excited state", the starting state is "de-excited" and the arrival state is "excited." Two conditions are disclosed, linked by a conjunction AND represented by V>18 and T<10. Once the semi-regimented is identified, a finite state machine (FSM) is obtained. To accomplish this, the semantic segments are assigned to the various objects that define the FSM. Specifically, two modes of operation of the coil, namely "excited" and "de-excited", fall with a state that presents the subject of the statement. The FSM extracted is given in Figure 7. The conditions of occurrence and the action appear on the transition.

In the case of multiple statements, the FSMs that are generated may be divided into parallel FSMs or hierarchical FSMs. For parallel FSMs, parallel decomposition is used to describe system modes that coexist. This representation is identified when all of the states that make up an FSM are always active at the same instant. Figure 8A is an example that illustrates a typical parallel decomposition in which, when state A is active, then states A1 and A2 are simultaneously active.

Figure 8B shows an example of hierarchical or exclusive FSMs. The exclusive OR decomposition is used for describing system modes that are mutually exclusive. When an FSM has this type of decomposition, then only one state can be active at the same time in so far as they are all states linked by the OR relation. In the example of Figure 8B, it may be noted that the states A and B can be activated individually but not simultaneously. Furthermore, if state A is activated, then also state A presents an exclusive decomposition, and hence the two states A1 and A2 can be activated individually but not simultaneously.

In both cases of Figures 8A and 8B, it is desirable to complete the regimentation by introducing the concept of context. The context, which is requested from the user, has the purpose of identifying the hierarchical levels of the FSMs that are generated or where the action is performed.

The following table provides situations that can arise by structuring two or more sentences differently.

| | | **NOMINAL SYNTAGMA** | **VERBAL SYNTAGMA** | | | | |
|---|---|---|---|---|---|---|---|
| **N** | **CONTEXT** | **SUBJECT** | **ACTION** | | | **CONDITIONS OF OCCURRENCE** | |
| | | | **Starting state** | **Result of action** | **Arrival state** | **OR conditions** | **AND conditions** |
| 1 | C1 | SN1 | SP1 | RA1 | SA1 | C1a | C1b |
| 2 | C2 | SN2 | SP2 | RA2 | SA2 | C2a | C2b |
| 3 | C3 | SN3 | SP3 | RA3 | SA3 | C3a | C3b |
| 4 | C1 | SN4 | SP4 | RA4 | SA4 | C4a | C4b |
| 5 | SN3 | SN5 | SP5 | RA5 | SA5 | C5a | C5b |
| 6 | C4 | SN6 | SP6 | RA6 | C3 | C6a | C6b |
| 7 | | SN7 | SP7 | RA7 | SA7 | C7a | C7b |
| 8 | SN5 | SN8 | C1 | RA8 | SA8 | C8a | C8b |

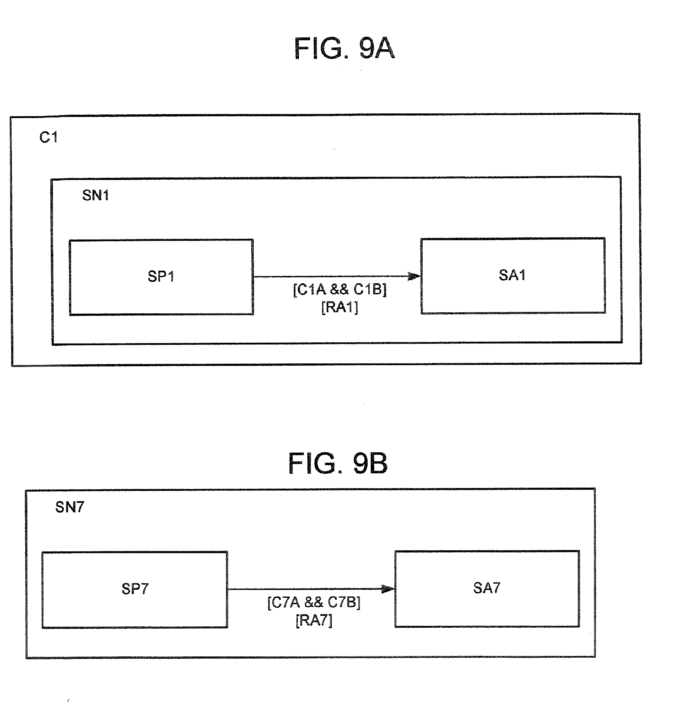

If Row 1 of the table is analyzed, it leads to the construction of an FSM at the level identified by the context C1. Figure 9A shows an example of the resulting state diagram.

If the user does not enter the context, the context parameter is not used and hence the automaton associated to the sentence is set provisionally to level 0. Thus, Figure 9B shows an example of a FSM generated from row 7 in the table, where the context field is not present.

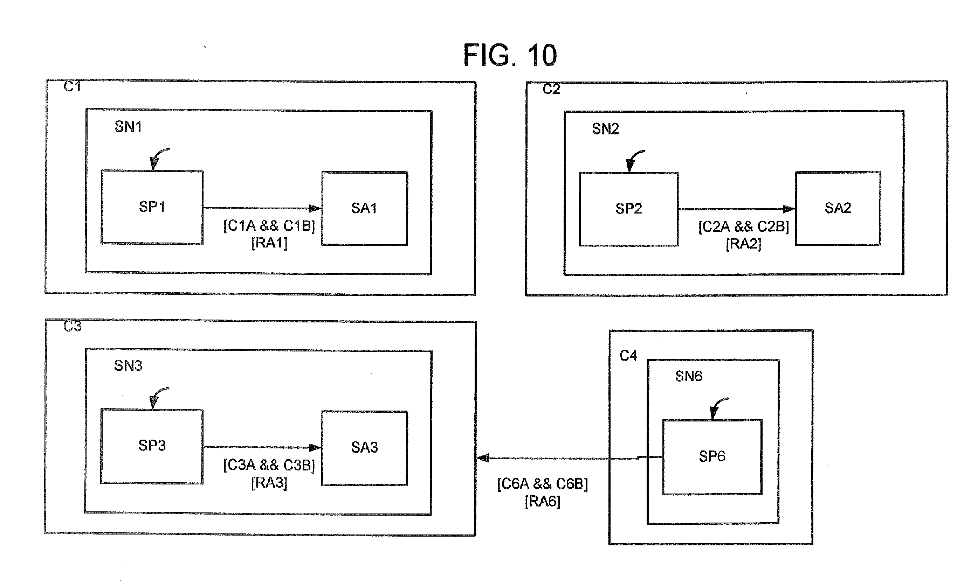

In the case of a statement set within a context not defined previously in the table, the regimentation leads to the definition of a parallel machine. This case is presented in rows 1, 2, 3, 5, and 7 wherein semi-regimented sentences are present, which are set in different contexts and hence give rise to FSMs that are parallel to each other. Figure 10 shows an example of FSMs for rows 1, 2, 3, and 5. The definition of parallel machines may also be obtained in the case of statements that have different subjects but are set within a single context. This case is presented in rows 1 and 4, where semi-regimented sentences are present, which have different subjects and are set in one and the same context.

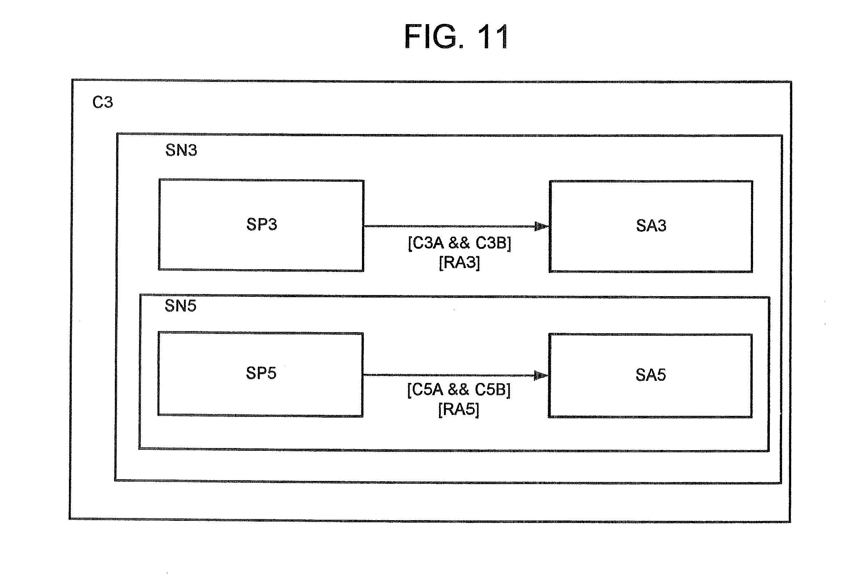

In the event of there being statements having a context that is the same as the subject of one or more other statements, these will create hierarchical FSMs or FSMs set within a pre-existing state identified by its own context. This case is presented in rows 3 and 5, where sentence 5 has a context that is the same as the subject of sentence 3. Figure 11 shows an example of a hierarchical FSM.

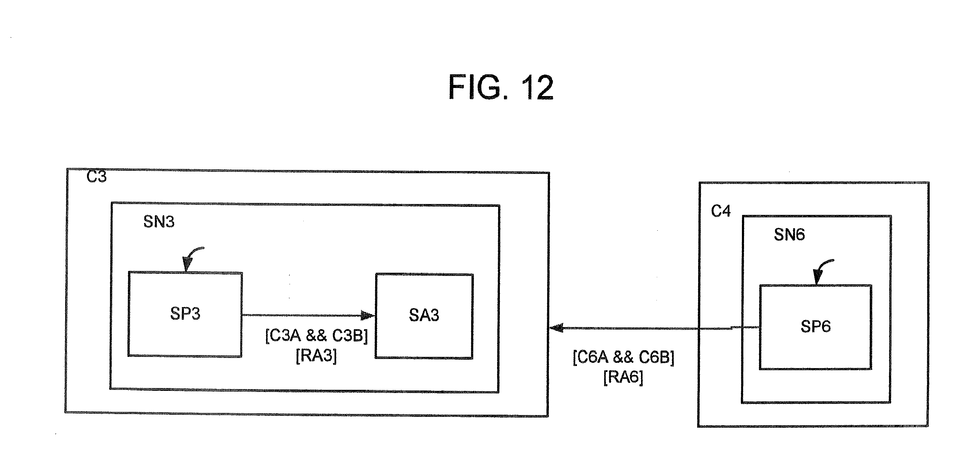

A particular case of transition between hierarchical FSMs occurs when the arrival state or starting state of a transition coincides with one of the contexts. In this case, a "super-transition" between the states is created. An example of arrival state coinciding with the context is given in Row 6 of the table. In this case the arrival state is at the same level as the starting one and there is hence a simple transition between states. Figure 12 shows an example of the FSM having a super-transition.

It is clear that numerous modifications and variants can be made to the present invention, all falling within the scope of the invention, as defined in the appended claims.

In particular, although an example interface design is shown, any number of designs may be used. Furthermore, although particular examples are used with finite state machines, the invention may be applied to any event-driven model. Finally, although it is described that the user must read the requirements in box 120 and then enter the necessary phrases in regimented form in area 112, the invention may be extended to include automatic transition from the requirements to the regimented form, so as to minimize user interaction.

## Claims

1. A method of receiving and transforming functionality requirements into an event-driven model, comprising:
receiving the functionality requirements through a user interface in a regimented natural-language form;
generating one or more event-driven models associated with the functionality requirements entered by the user; and
parsing one or more of the event-driven models to find missing or contradictory conditions in the functionality requirements to ensure the requirements are complete.

2. The method of claim 1, further including parsing the received functionality requirements to find unclear phrases entered by the user.

3. The method of claim 2, further including displaying warnings to the user in response to finding unclear phrases.

4. The method of claim 1, wherein receiving functionality requirements further includes receiving a statement indicating a condition is to be later decided.

5. The method of claim 4, further including displaying warnings to the user after generating one or more event-driven models that a condition still exists to be later decided.

6. The method of claim 1, further including displaying the missing or contradictory conditions to the user.

7. The method of claim 1, further including generating a finalized dynamic event-driven model by combining several of the event-driven models together.

8. The method of claim 7, further including simulating the finalized dynamic event-driven model.

9. The method of claim 7, further including validating the finalized dynamic event-driven model.

10. The method of claim 2, wherein parsing the received functionality requirements to find unclear phrases includes identifying one or more of the following: a context, a starting state, a transition, a result of the transition, an arrival state, and any AND/OR conditions.

11. The method claim 1, wherein generating one or more event-driven models includes generating the following: a starting-state node, inputs to the starting-state node, state transitions based on the inputs, a next-state node, and an association between the starting-state node with the next-state node using state transitions.

12. A system to receive and transform system requirements into an event-driven model, comprising:
a user interface having displayed thereon a template including separate fields to form a regimented natural language;
an engine coupled to the user interface to generate an event-driven model associated with user input received in the fields of the user interface; and
a parser coupled to the engine to analyze the event-driven model to find missing or contradictory conditions.

13. The system of claim 12, further including an ordered natural-language parser coupled to the user interface to check for errors entered by the user.

14. The system of claim 12, further including a model combiner coupled to the parser.

15. The system of claim 12, further including a simulator coupled to the parser.

16. The system of claim 15, further including a validator coupled to the simulator.

17. The system of claim 12, wherein the fields of the user interface include at least a start-state field, an end-state field, and a condition field.

18. A system for receiving and transforming system requirements into an event-driven model, comprising:
means for receiving functionality requirements through a user interface in a regimented natural-language form;
means for generating one or more event-driven models associated with the functionality requirements entered by the user; and
means for parsing one or more of the event-driven models.

19. The system of claim 18, further including means for parsing ordered natural language.

20. The system of claim 18, further including means for simulating and validating.

## Amended claims

### Amended claims in accordance with Rule 86(2) EPC.

**1.** A method of receiving and transforming functionality requirements into an event-driven model, comprising:
receiving the functionality requirements through a user interface in a regimented natural-language form;
generating one or more event-driven models associated with the functionality requirements entered by the user;
parsing one or more of the event-driven models to find missing or contradictory conditions in the functionality requirements to ensure the requirements are complete and displaying to the user the functionality requirements with the missing or contradictory conditions.

**2.** The method of claim 1, further including parsing the received functionality requirements to find unclear phrases entered by the user.

**3.** The method of claim 2, further including displaying warnings to the user in response to finding unclear phrases.

**4.** The method of claim 1, wherein receiving functionality requirements further includes receiving a statement indicating a condition is to be later decided.

**5.** The method of claim 4, further including displaying warnings to the user after generating one or more event-driven models that a condition still exists to be later decided.

**7.** The method of claim 1, further including generating a finalized dynamic event-driven model by combining several of the event-driven models together.

**8.** The method of claim 7, further including simulating the finalized dynamic event-driven model.

**9.** The method of claim 7, further including validating the finalized dynamic event-driven model.

**10.** The method of claim 2, wherein parsing the received functionality requirements to find unclear phrases includes identifying one or more of the following: a context, a starting state, a transition, a result of the transition, an arrival state, and any AND/OR conditions.

**11.** The method claim 1, wherein generating one or more event-driven models includes generating the following: a starting-state node, inputs to the starting-state node, state transitions based on the inputs, a next-state node, and an association between the starting-state node with the next-state node using state transitions.

**12.** A system to receive and transform system requirements into an event-driven model, comprising:
a user interface having displayed thereon a template including separate fields to form a regimented natural language;
an engine coupled to the user interface to generate an event-driven model associated with user input received in the fields of the user interface; and
a parser coupled to the engine to analyze the event-driven model to find missing or contradictory conditions and a user interface to display to the user fonctionality requirements with missing or contradictory conditions.

**13.** The system of claim 12, further including an ordered natural-language parser coupled to the user interface to check for errors entered by the user.

**14.** The system of claim 12, further including a model combiner coupled to the parser.

**15.** The system of claim 12, further including a simulator coupled to the parser.

**16.** The system of claim 15, further including a validator coupled to the simulator.

**17.** The system of claim 12, wherein the fields of the user interface include at least a start-state field, an end-state field, and a condition field.
